# EUROPEAN PATENT SPECIFICATION

(11) **EP 2 316 985 B1**
(45) Date of publication and mention of the grant of the patent: **04.12.2013**
(21) Application number: 10251790.1
(22) Date of filing: 13.10.2010
(51) Int. Cl.: C23C 14/56, C23C 14/20, B05D 7/24

(54) **Apparatus for producing multilayer sheet and method of producing the multilayer sheet**
Vorrichtung zur Herstellung einer mehrschichtigen Folie und Verfahren zur Herstellung der mehrschichtigen Folie
Appareil pour la production d'une feuille multicouche et procédé de production de la feuille multicouche

(30) Priority: 15.10.2009 JP 2009238178
(43) Date of publication of application: 04.05.2011
(73) Proprietor: Kojima Press Industry Co., Ltd., Toyota-shi, Aichi-ken, 471-0875 (JP); ULVAC, INC., Chigasaki-shi Kanagawa 253-8543 (JP)
(72) Inventor: Ito, Kaoru, Toyota-shi, Aichi-ken, 471-0875 (JP); Noguchi, Masumi, Toyota-shi, Aichi-ken, 471-0875 (JP); Tanaka, Hideaki, Toyota-shi, Aichi-ken, 471-0875 (JP); Ikeda, Hiroyuki, Toyota-shi, Aichi-ken, 471-0875 (JP); Shimomura, Makoto, Chigasaki-shi Kanagawa, 253-8543 (JP); Tada, Isao, Chigasaki-shi Kanagawa, 253-8543 (JP); Hayashi, Nobuhiro, Chigasaki-shi Kanagawa, 253-8543 (JP); Irikura, Hagane, Tsukuba-shi Ibaraki, 300-2635 (JP)
(74) Representative: Naylor, Matthew John

(56) References cited:
- JP-A- 2000 338 901
- JP-A- 2001 261 867
- US-A- 4 842 893

## Description

### BACKGROUND OF THE INVENTION

### Field of the Invention

The present invention relates to an apparatus for producing a multilayer sheet and a method of producing the multilayer sheet. More particularly, the present invention relates to a novel apparatus for producing a multilayer sheet by forming a vapor-deposited metal film on both surfaces of a resin film, and forming a vapor-deposited polymer film on at least one of the vapor-deposited metal films, and the present invention also relates to a method of producing such a multilayer sheet.

### Discussion of Related Art

Conventionally, a multilayer sheet is used in a wide variety of applications, which is obtained by forming a vapor-deposited metal film on both surfaces of a resin film, and forming a vapor-deposited polymer film on at least one of the vapor-deposited metal films. For example, the multilayer sheet is used as a material of a film capacitor used in an electric device, as a packing sheet, or as a protection sheet for various articles.

Generally, in the formation of such a multilayer sheet, initially, a metallized film is formed by forming a vapor-deposited metal film on both surfaces of a resin film by using a known continuous vacuum deposition apparatus. In the formation of the metallized film, typically, a long metallized film is obtained as a roll. Then, as described in JP-A-2001-261867, a vapor-deposited polymer film is formed on at least one of the vapor-deposited metal film formed on respective surfaces of the metallized film by using a roll-to-roll vacuum deposition polymerization apparatus which is a separate apparatus from the apparatus for forming a metallized film (a continuous vacuum deposition apparatus). Accordingly, the intended multilayer sheet is formed.

When the multilayer sheet is formed by such a conventional technique, a continuous vacuum deposition apparatus for forming a vapor-deposited metal film on both surfaces of a resin film and a roll-to-roll vacuum deposition polymerization apparatus for forming a vapor-deposited polymer film on the vapor-deposited metal film are both needed. In addition, when these two kinds of apparatus are used, the metallized film formed in a continuous vacuum deposition apparatus needs to be removed from the continuous vacuum deposition apparatus and set in the roll-to-roll vacuum deposition polymerization apparatus. At this time, the inside of the continuous vacuum deposition apparatus should be changed to an open-to-air condition from a vacuum condition, and the inside of the roll-to-roll vacuum deposition polymerization apparatus should be changed to a vacuum condition from an open-to-air condition, which is troublesome.

Therefore, the conventional production technique of multilayer sheet requires not only high equipment cost and running cost, but also requires operations that involve a lot of time and labor.

JP 2000338901 A shows the coating both sides of a transparent plastic film material in a single vacuum coating device.

### SUMMARY OF THE INVENTION

The present invention has been made in the light of the situations described above, and an object of the invention is to provide an apparatus for producing a multilayer sheet including a resin film, a vapor-deposited metal film formed on both surfaces of the resin film, and a vapor-deposited polymer film formed on at least one of the vapor-deposited metal film, at a sufficiently low cost and with excellent productivity, and it is another object of the invention to provide a method of producing the multilayer sheet.

To achieve the aforementioned objects, or to solve the problems understood from description throughout the present specification and drawings, the present invention may be preferably embodied according to various aspects which will be described below. Each aspect described below may be employed in any combination. It is to be understood that the aspects and technical features of the present invention are not limited to those described below, and can be recognized based on the inventive concept disclosed in the whole specification and drawings.

<1> An apparatus for producing a multilayer sheet comprising: (a) a vacuum chamber including, in an inside thereof, a feeding roller for unwinding a resin film from a roll of the resin film, and a take up roller for winding the resin film unwound from the roll; (b) exhaust means for exhausting atmosphere in the vacuum chamber, whereby the inside of the vacuum chamber is in a vacuum state; (c) a first roller disposed in the vacuum chamber, the resin film unwound from the roll of the resin film by the feeding roller being wound on the first roller such that one surface of the resin film faces outwardly: (d) a second roller disposed in the vacuum chamber, the resin film sent from the first roller being wound on the second roller such that the one surface of the resin film faces outwardly; (e) a third roller disposed in the vacuum chamber, the resin film sent from the second roller being wound on the third roller such that the other surface of the resin film faces outwardly; (f) driving means rotary driving at least one of the feeding roller, the take up roller, the first roller, the second roller, and the third roller, thereby sending the resin film from the feeding roller side to the take up roller side: (g) first metal vapor deposition means for forming a first vapor-deposited metal film on the one surface of the resin film, at a periphery of the first roller; (h) first vapor deposition polymerization means for forming a first vapor-deposited polymer film on the first vapor-deposited metal film formed on the one surface of the resin film, at a periphery of the second roller; and (i) second metal vapor deposition means for forming a second vapor-deposited metal film on the other surface of the resin film, at a periphery of the third roller, whereby the multilayer sheet comprising the resin film, the first vapor-deposited metal film, the second vapor-deposited metal film and the first vapor-deposited polymer film is obtained.

<2> The apparatus for producing a multilayer sheet according to the above aspect <1>, further comprising a first auxiliary vacuum chamber disposed in the vacuum chamber and first auxiliary exhaust means operable separately from the exhaust means, the first auxiliary vacuum chamber being adapted to contain a part of the one surface of the resin film wound on the second roller and the first auxiliary exhaust means being adapted to exhaust the atmosphere in the first auxiliary vacuum chamber such that the first auxiliary vacuum chamber has a different degree of vacuum from that of the vacuum chamber, thereby forming the first vapor-deposited polymer film on the first vapor-deposited metal film in the first auxiliary vacuum chamber by vapor deposition polymerization.

<3> The apparatus for producing a multilayer sheet according to the above aspect <1> or <2>, further comprising first plasma treatment means for introducing a three-dimensional cross-linked structure into the first vapor-deposited polymer film.

<4> The apparatus for producing a multilayer sheet according to the above aspect <1>, further comprising: a fourth roller disposed in the vacuum chamber, the resin film sent from the third roller being wound on the fourth roller such that the other surface of the resin film faces outwardly; and second vapor deposition polymerization means for forming a second vapor-deposited polymer film by vapor deposition polymerization on the second vapor-deposited metal film formed on the other surface of the resin film, at a periphery of the fourth roller, wherein the driving means rotary drives at least one of the feeding roller, the take up roller, the first roller, the second roller, the third roller, and the fourth roller, thereby sending the resin film from the feeding roller side to the take up roller side, whereby the multilayer sheet comprising the resin film, the first vapor-deposited metal film, the second vapor-deposited metal film, the first vapor-deposited polymer film and the second vapor-deposited polymer film is obtained.

<5> The apparatus for producing a multilayer sheet according to the above aspect <4>, further comprising: a first auxiliary vacuum chamber and a second auxiliary vacuum chamber in the vacuum chamber, the first auxiliary vacuum chamber being adapted to contain a part of the one surface of the resin film wound on the second roller, and the second auxiliary vacuum chamber being adapted to contain a part of the other surface of the resin film wound on the fourth roller; and first auxiliary exhaust means and second auxiliary exhaust means operable separately from the exhaust means, the first auxiliary exhaust means and the second auxiliary exhaust means being adapted to exhaust the atmosphere in the first auxiliary vacuum chamber and the second auxiliary vacuum chamber, respectively, such that each of the first auxiliary vacuum chamber and the second auxiliary vacuum chamber has a different degree of vacuum from that of the vacuum chamber, thereby forming the first vapor-deposited polymer film on the first vapor-deposited metal film in the first auxiliary vacuum chamber by the first vapor deposition polymerization means and the second vapor-deposited polymer film on the second vapor-deposited metal film in the second auxiliary vacuum chamber by the second vapor deposition polymerization means.

<6> The apparatus for producing a multilayer sheet according to the above aspect <4> or <5>, further comprising first plasma treatment means and second plasma treatment means in the vacuum chamber, the first plasma treatment means introducing a three-dimensional cross-linked structure to the first vapor-deposited polymer film and the second plasma treatment means introducing a three-dimensional cross-linked structure into the second vapor-deposited polymer film.

<7> The apparatus for producing a multilayer sheet according to any one of the above aspects <1> to <6>, in which the multilayer sheet is used to produce a film capacitor.

<8> A method of producing a multilayer sheet, comprising the steps of: (a) providing a deposition apparatus including a vacuum chamber having a first roller, a second roller, and a third roller therein, in which a resin film in the vacuum chamber is wound on the first roller, the second roller and the third roller in the order of the description; (b) traveling the resin film from the first roller side to the third roller side while the vacuum chamber is in a vacuum state, the resin film being wound on the first roller and the second roller such that one surface of the resin film faces outwardly and the resin film sent from the second roller being wound on the third roller such that the other surface thereof faces outwardly; (c) forming a first vapor-deposited metal film on the one surface of the resin film at a periphery of the first roller; (d) forming a first vapor-deposited polymer film on the first vapor-deposited metal film formed on the one surface of the resin film, at a periphery of the second roller; and (e) forming a second vapor-deposited metal film on the other surface of the resin film, at a periphery of the third roller, whereby the multilayer sheet comprising the resin film, the first vapor-deposited metal film, the second vapor-deposited metal film and the first vapor-deposited polymer film is obtained.

<9> The method of producing a multilayer sheet according to the above aspect <8>, further comprising the step of treating the first vapor-deposited polymer film by plasma treatment, whereby a three-dimensional cross-linked structure is introduced to the first vapor-deposited polymer film.

<10> A method of producing a film capacitor, comprising the step of winding the multilayer sheet obtained according to the above aspect <8> or <9> at least one time, or stacking a plurality of multilayer sheets with each other.

<11> The method of producing a film capacitor according to the above aspect <10>, in which the first vapor-deposited polymer film is a polyurea resin film.

<12> The method of producing a film capacitor according to the above aspect <10> or <11>, in which the first vapor-deposited polymer film has a higher dielectric constant than the resin film.

<13> The method of producing a film capacitor according to any one of the above aspects <10> to <12>, in which the first vapor-deposited polymer film is formed to have a thickness in a range of from 0.01 to 10 µm.

<14> The method of producing a film capacitor according to any one of the above aspects <10> to <13>, in which the resin film is formed of polypropylene, and the first vapor-deposited polymer film is formed of polyurea resin.

<15> > The method of producing a film capacitor according to any one of the above aspects <10> to <14>, in which the multilayer sheet is wound such that the first vapor-deposited polymer film is positioned innermost.

<16> The method of producing a film capacitor according to any one of the above aspects <10> to <15>, in which the multilayer sheet is wound a plurality of times.

<17> A film capacitor according to any one of the above aspects <10> to <14>, in which the multilayer sheet comprises a plurality of multilayer sheets and the plurality of multilayer sheets are stacked such that the first vapor-deposited polymer film and one of the first and second vapor-deposited metal films are stacked with each other.

<18> The method of producing a multilayer sheet according to the above aspect <8>, in which the vacuum chamber further includes a fourth roller, and the resin film in the vacuum chamber is traveled from the first roller side to the fourth roller side while the resin film is further wound on the fourth roller such that the other surface thereof faces outwardly, thereby further forming a second vapor-deposited polymer film on the second vapor-deposited metal film formed on the other surface of the resin film, at a periphery of the fourth roller, whereby the multilayer sheet comprising the resin film, the first vapor-deposited metal film, the second vapor-deposited metal film, the first vapor-deposited polymer film and the second vapor-deposited polymer film is obtained.

<19> The method of producing a multilayer sheet according to the above aspect <18>, further comprising the step of treating each of the first vapor-deposited polymer film and the second vapor-deposited polymer film by plasma treatment, whereby a three-dimensional cross-linked structure is introduced to the first vapor-deposited polymer film and the second vapor-deposited polymer film.

<20> The method of producing a film capacitor, comprising the step of winding the multilayer sheet obtained according to the above aspect <18> or <19> at least one time or stacking a plurality of multilayer sheets with each other.

<21> The method of producing a film capacitor according to the above aspect <20>, the first and second vapor-deposited polymer films are polyurea resin films.

<22> The method of producing a film capacitor according to the above aspect <20> or <21>, in which each of the first vapor-deposited polymer film and the second vapor-deposited polymer film has a higher dielectric constant than the vapor-deposited polymer film.

<23> The method of producing a film capacitor according to any one of the above aspects <20> to <22>, in which each of the first vapor-deposited polymer film and the second vapor-deposited polymer film is formed to have a thickness in a range of from 0.01 to 10 µm.

<24> The method of producing a film capacitor according to any one of the above aspects <20> to <23>, in which the resin film is formed of polypropylene, and the first vapor-deposited polymer film and the second vapor-deposited polymer film are formed of polyurea resin.

<25> The method of producing a film capacitor according to any one of the above aspects <20> to <24>, in which the multilayer sheet is wound a plurality of times.

As described above, of the apparatus for producing a multilayer sheet according to the present invention, the apparatus including the first to third rollers is arranged to form the first vapor-deposited metal film and the second vapor-deposited metal film on respective surfaces of the resin film and form the first vapor-deposited polymer film on the first vapor-deposited metal film in one vacuum chamber, while the resin film is unwound from the feeding roller and sent to the take up roller.

Further, of the apparatus for producing the multilayer sheet according to the present invention, the apparatus including the first to fourth rollers is also arranged to form the first vapor-deposited metal film and the second vapor-deposited metal film on respective surfaces of the resin film, the first vapor-deposited polymer film on the first vapor-deposited metal film, and the second vapor-deposited polymer film on the second vapor-deposited metal film in one vacuum chamber, while the resin film is unwound from the feeding roller and sent to the take up roller.

Consequently, when the apparatus for producing a multilayer sheet according to the present invention is used, there is no need to provide a continuous vacuum vapor deposition apparatus for forming a vapor-deposited metal film and a roll-to-roll vacuum deposition polymerization apparatus for forming a vapor-deposited polymer film, separately. Further, there is no need to set the metallized film on the roll-to-roll vacuum deposition polymerization apparatus after the metallized film constituted of a resin film and vapor-deposited metal films formed on respective surfaces of the resin film are removed from the continuous vacuum vapor deposition apparatus. Further, there is no need to control the pressure in the apparatuses separately so as to be in a vacuum state or an open-to-air condition in the above operation, which is troublesome and time-consuming operation.

Therefore, the apparatus for producing a multilayer sheet of the present invention can advantageously form a multilayer sheet including a vapor-deposited metal film formed on both surfaces of the resin film and a vapor-deposited polymer film formed on at least one surface of the vapor-deposited metal film, at a sufficiently low cost and with excellent productivity.

The method of producing a multilayer sheet according to the present invention can have substantially the same advantages obtained in the apparatus for producing a multilayer sheet according to the present invention.

### BRIEF DESCRIPTION OF THE DRAWINGS

The above and other objects, features, advantages and technical and industrial significance of the present invention will be better understood by reading the following detailed description of a preferred embodiment of the invention, when considered in connection with the accompanying drawings, in which:
Fig. 1 is a partially enlarged cross sectional view showing one embodiment of a multilayer sheet formed by using an apparatus for producing a multilayer sheet according to present invention;
Fig. 2 is a cross sectional view showing one embodiment of an apparatus for producing a multilayer sheet according to the present invention;
Fig. 3 is an explanation view showing one process in the formation of a multilayer sheet by using the apparatus shown in Fig. 2, and showing a state in which the resin film is wound on the feeding roller, the take up roller, and the first to third rollers;
Fig. 4 is a view corresponding to Fig. 1 and showing another embodiment of a multilayer sheet formed by using the apparatus for producing a multilayer sheet according to the present invention; and
Fig. 5 is a view corresponding to Fig. 2 and showing another embodiment of an apparatus for producing a multilayer sheet according to the present invention.

### DETAILED DESCRIPTION OF THE INVENTION

To further clarify the present invention, there will be described in detail embodiments of the invention with reference to the accompanying drawings.

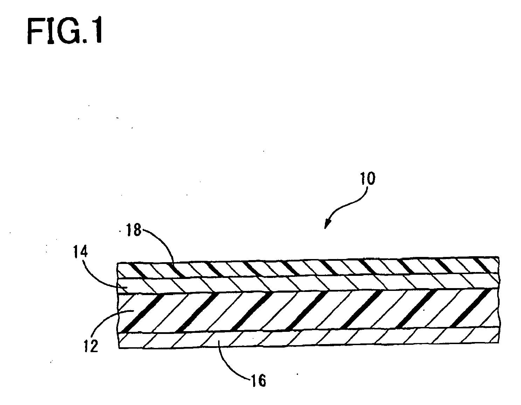

Initially, Fig. 1 shows a part of a multilayer sheet, which constitutes a film capacitor, in a cross sectional view, as one embodiment of a multilayer sheet that is formed by using an apparatus having a structure according to the present invention. As apparent from Fig. 1, a multilayer sheet 10 includes a resin film 12 as a base, a first electrode film 14 of a first vapor-deposited metal film, formed on one surface of the resin film 12 which gives a main surface (an upper surface of the resin film 12 in Fig. 1), and a second electrode film 16 of a second vapor-deposited metal film, formed on the other surface of the resin film 12 (an under surface of the resin film 12 in Fig. 1). Further, on the first electrode film 14, a first dielectric film 18 is formed as a first vapor-deposited polymer film.

Here, the resin film 12 as a base of the multilayer sheet 10 is formed of a stretched film made of polypropylene and has a thickness of about 1 to 10 µm. However, the material of the resin film 12 is not limited to polypropylene. Instead of polypropylene, resin materials such as polyethylene terephthalate, polyphenylene sulfide, polyethylene naphtalate, and the like, which are used as materials of resin films of conventional film capacitors, can be suitably used. It is to be understood that, when the multilayer sheet 10 is used for a purpose other than the production of a film capacitor, other resin materials than the exemplified materials can be used as a material of the resin film 12.

The first electrode film 14 and the second electrode film 16, which are formed on respective surfaces of the resin film 12, are made of vapor-deposited metal films formed by a vacuum evaporation method. Thickness of each of the electrode films 14 and 16 is suitably determined such that membrane resistance of each of the electrode films 14, 16 is to be in a range of from about 1 to 25Ω/cm².

Like the conventional film capacitors, materials of the first and second electrode films 14, 16 are suitably selected from metallic materials such as aluminum, zinc and the like, depending on the material of the resin film 12, for example. The materials of the first electrode film 14 and the second electrode film 16 are not necessarily the same metallic materials. The materials are determined depending on the required performance for the film capacitor, for example. In addition, the thickness and membrane resistance of each of the first electrode film 14 and the second electrode film 16 is set at the same value or different value depending on the required performance or the like for the film capacitor. When the multilayer sheet 10 is used for a purpose other than the production of a film capacitor, formation material and thickness of the vapor-deposited metal film (corresponding to the electrode films 14, 16 of the present embodiment) may be suitably changed depending on the purpose, for example.

A first dielectric film 18 formed on an outer surface of the first electrode film 14, specifically, on a surface positioned at the side opposite to the resin film 12, is made of a polyurea resin film. The first dielectric film 18 is formed in a vacuum according to a conventional vapor deposition polymerization.

As described above, the first dielectric film 18 is formed by a vapor-deposited polymer film that is formed of a polymer generated in a vacuum or under reduced pressure. Consequently, the thickness of the first dielectric film 18 can be controlled on a nanoscale. Therefore, not only the thickness of the film is controlled so as to be extremely small and uniform, but also impurities in the film is sufficiently reduced. Generally, the thickness of the first dielectric film 18 is controlled to be within a range of about 0.01 to 10 µm.

The first dielectric film 18 is not limited to the above polyurea resin film. Any resin film that can be formed by a known vapor deposition polymerization may be employed. Examples of the resin films include polyamide resin film, polyimide resin film, polyamideimide resin film, polyester resin film, polyazomethine resin film, polyurethane resin film, and acrylic resin film. Among the above listed resin films, one having a higher dielectric constant than the resin film 12 is favorably employed. The capacitance of the film capacitor can be effectively increased by the formation of the first dielectric film 18 by using the resin film having a higher dielectric constant. As materials of the resin film 12 and the first dielectric film 18 which have different dielectric constant are not limited to the combination of the polypropylene and the polyurea described above.

Of the resin films having high dielectric constant described above, the polyurea resin film is favorably used to form the first dielectric film 18. This is because that the polyurea resin require no heat treatment in the polymerization of monomers (diisocyanate and diamine) and the polyurea resin is formed in the addition polymerization reaction in which no elimination of water, alcohol and the like occur. Consequently, equipments (facilities) for heat treatment in the polymerization of monomers is not necessary and cost can be reduced. Further, deformation of the resin film 12 by the heat during the heat treatment can be effectively avoided. Furthermore, there is no need to remove water, alcohol, and the like, which are eliminated by the polymerization reaction, from the vacuum chamber in which the polymerization reaction proceeds. Therefore, equipments for the removal is not necessary and cost can be reduced. When the multilayer sheet 10 is used for a purpose other than the production of a film capacitor, formation material and thickness of the vapor-deposited polymer film (the first dielectric film 18 of the present embodiment) may be suitably changed depending on the purpose, for example.

In this embodiment, on a surface of the first dielectric film 18 which is formed on the first electrode film 14, plasma treatment is further performed to introduce the three-dimensional cross-linked structure into the first dielectric film 18. Accordingly, the withstand voltage of the first dielectric film 18 can be advantageously improved.

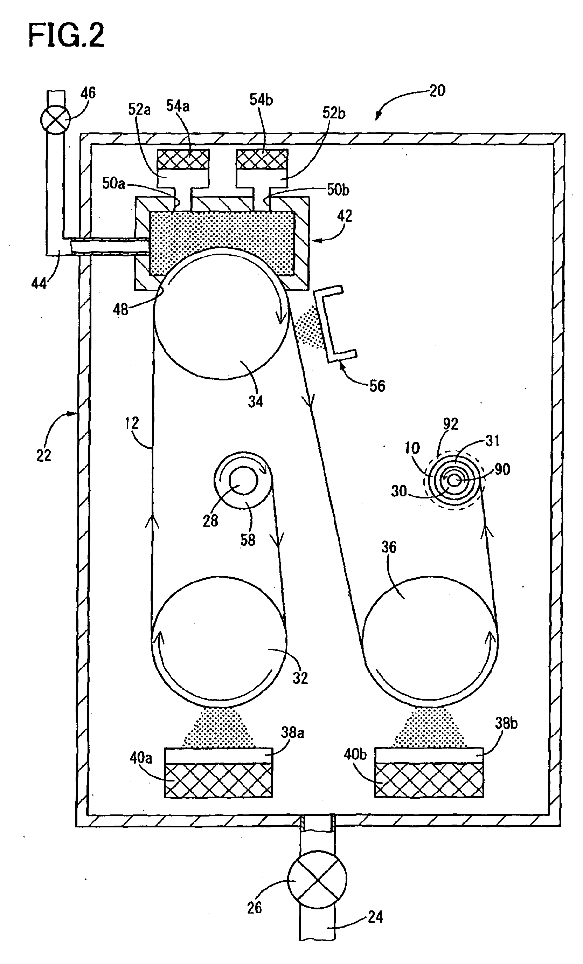

In the formation of the multilayer sheet 10, an apparatus for producing a multilayer sheet, or a film-forming apparatus 20 (deposition apparatus) shown in Fig. 2 is used, for example.

The film-forming apparatus 20 includes a vacuum chamber 22 having a longitudinal rectangular shape. To a side wall of the vacuum chamber 22, an exhaust pipe 24 is connected, and the exhaust pipe 24 is also connected to a vacuum pump 26. Accordingly, atmosphere such as air in the vacuum chamber 22 is exhausted to the outside by an operation of the vacuum pump 26 and the inside of the vacuum chamber 22 becomes a vacuum state. As apparent from this, in the present embodiment, the exhaust means is constituted by the exhaust pipe 24 and the vacuum pump 26. Here, by the operation of the vacuum pump 26, a pressure (degree of vacuum) in the vacuum chamber 22 is controlled to be within a range of from about 10⁻⁴ to 100 Pa.

In the vacuum chamber 22, a feeding roller 28 and a take up roller 30 are disposed. The feeding roller 28 and the take up roller 30 are positioned in a middle in a longitudinal direction (up and down direction in Fig. 2) and positioned in the left side and the right side in a width direction (right to left direction in Fig. 2), respectively. Further, the take up roller 30 is connected to an electrical motor 92, which is a constitution of driving means. The driving means are constituted by the electrical motor 92 and a rotational axis 90. Accordingly, the take up roller 30 can be rotationally driven/suspended by driving/suspending the electrical motor 92.

Further, a first roller 32, a second roller 34, and a third roller 36 are disposed in the vacuum chamber 22. The first to third rollers 32, 34, and 36 have the same outside diameter. The first roller 32 and the second roller 34 are positioned such that they are positioned in the lower side and the upper side, respectively, with the feeding roller 28 disposed therebetween in a longitudinal direction. The third roller 36 is positioned so as to be adjacent to the first roller 32 in a width direction of the vacuum chamber 22.

In the vacuum chamber 22, a first deposition material 38a formed of aluminum or aluminum alloy (hereinafter, collectively referred to as aluminum) is disposed by using a holder, for example, which is not shown, at a position opposite to the feeding roller 28 with the first roller 32 interposed therebetween, so as to face an outer surface of the first roller 32 with a suitable distance therebetween. Further, a second deposition material 38b formed of aluminum or aluminum alloy (hereinafter, collectively referred to as aluminum) is disposed by using a holder, for example, at a position opposite to the take up roller 30 with the third roller 36 interposed therebetween, so as to face an outer surface of the third roller 36 with a suitable distance therebetween. Further, a first heater 40a and a second heater 40b for heating the respective deposition materials 38a, 38b are provided on the first and second deposition materials 38a, 38b on the side opposite to the first and third rollers 32, 36 side.

In the vacuum chamber 22, a first auxiliary vacuum chamber 42 is disposed at a position opposite to the feeding roller 28 side with the second roller 34 interposed therebetween. To the first auxiliary vacuum chamber 42, a first auxiliary exhaust pipe 44 that extends from the outside of the vacuum chamber 22 through a side wall of the vacuum chamber 22 is connected. Further, a first auxiliary vacuum pump 46 is connected to the first auxiliary exhaust pipe 44 at a protruding portion thereof which extends from the vacuum chamber 22 to the outside. Furthermore, a window 48 is formed in a side wall of the first auxiliary vacuum chamber 42. Through the window 48, an outer surface of a part of the second roller 34 is exposed to the inside of the first auxiliary vacuum chamber 42.

The first auxiliary vacuum pump 46 is operated separately from the vacuum pump 26, so that atmosphere such as air in the first auxiliary vacuum chamber 42 is exhausted to the outside through the first auxiliary exhaust pipe 44. As apparent from this, in the present embodiment, the first auxiliary exhaust means is constituted by the first auxiliary vacuum pipe 44 and the first auxiliary vacuum pump 46. Therefore, inside of the first auxiliary vacuum chamber 42 can be a vacuum state having a pressure different from the vacuum chamber 22. Preferably, the degree of vacuum in the first auxiliary vacuum chamber 42 is higher than that of the vacuum chamber 22.

Further, in the first auxiliary vacuum chamber 42, two openings 50a, 50b are formed in a side wall opposing to the side wall having the window 48. Then, two monomer input pots 52a, 52b are connected through the respective openings 50a, 50b. In one of the two monomer input pots 52a, 52b, a predetermined amount of diisocyanate is contained. In the other one of the two monomer input pots 52a, 52b, a predetermined amount of diamine is contained. Further, a third heater 54a and a fourth heater 54b for heating a raw material or monomer in each of the monomer input pots 52a, 52b are provided at the respective monomer input pots 52a, 52b on the side opposite to the openings of the first auxiliary vacuum chamber 42. It is to be understood that the monomers in the monomer input pots 52a, 52b are suitably changed depending on kinds of polymer providing the first dielectric film 18 formed by vapor deposition polymerization.

In addition, a first plasma generator 56 as plasma treatment means is disposed in the vacuum chamber 22 so as to be positioned close to the second roller 34, at a side of the second roller 34 from which a resin film 12, which will be described later, is sent to the third roller 36. The first plasma generator 56 has a conventionally known structure, for example, in which plasma is generated by a laser.

In the formation of the multilayer sheet 10 by using the film-forming apparatus 20 according to the present embodiment, the procedure described below is followed, for example.

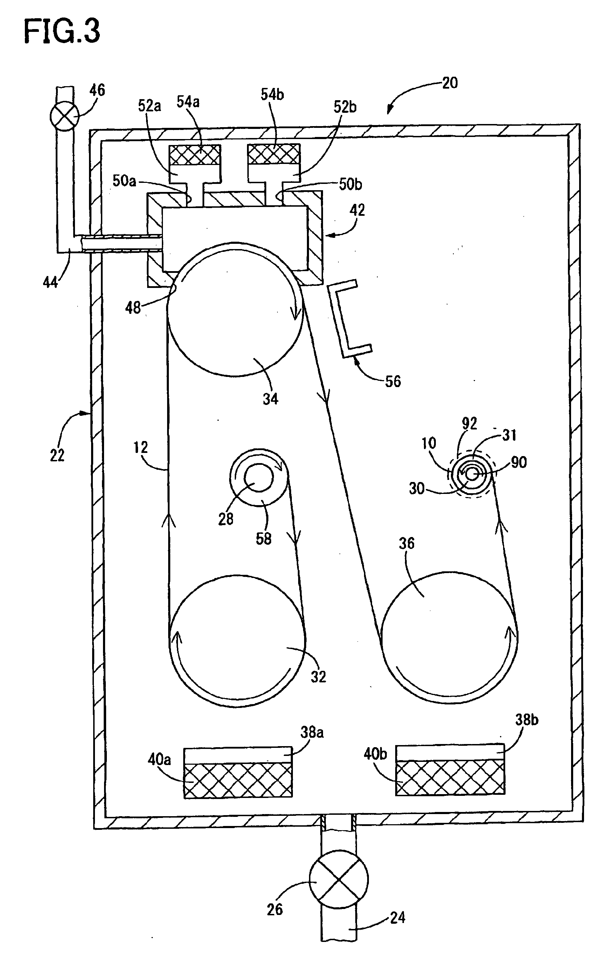

Initially, as shown in Fig. 3, a roll 58 of the resin film 12 is disposed outwardly of the feeding roller 28. Then, a part of the resin film 12 is unwound from the roll 58, and wound over the first roller 32 and the second roller 34.

Specifically, the resin film 12 is wound on the first and second rollers 32, 34 such that one surface of the resin film 12 is not contacted with the periphery of the first and second rollers 32, 34 and is exposed to the outside. In other words, the resin film 12 is wound over the first and second rollers 32, 34 such that one surface of the resin film 12 becomes an outer surface. Due to this arrangement, the one surface of the resin film 12 that faces outwardly on the periphery of the first roller 32 is opposed to the first deposition material 38a with a predetermined distance therebetween. Further, the one surface of the resin film 12 that faces outwardly on the periphery of the second roller 34 is contained in the first auxiliary vacuum chamber 42 while being exposed to the inside the first auxiliary vacuum chamber 42.

Then, the part of the resin film 12 sent from the second roller 34 to the side opposite to the first roller 32 is wound on the third roller 36. Specifically, the part of the resin film 12 is wound on the third roller 36 such that the other surface of the resin film 12 than the surface facing outwardly on the periphery of the first and second rollers 32, 34 faces outwardly on the third roller 36. In other words, the resin film 12 is wound on the third roller 36 such that the other surface of the resin film 12 becomes an outer surface. Accordingly, the other surface of the resin film 12, which faces outwardly on the periphery of the third roller 36, is positioned so as to be opposed to the second deposition material 38b with a predetermined distance therebetween.

The part of the resin film 12 sent from the third roller 36 to the side opposite to the second roller 34 is wound over a take up reel 31 set on the take up roller 30, thereby being releasably fixed.

Then, in the above state, the vacuum pump 26 is operated to reduce the pressure in the vacuum chamber 22 to about 10⁻⁴ to 100 Pa, thereby obtaining a vacuum state. At the same time, the first auxiliary vacuum pump 46 is operated to reduce the pressure in the first auxiliary vacuum chamber 42 to about 10⁻⁵ to 10 Pa, thereby obtaining a vacuum state. Preferably, the degree of vacuum in the first auxiliary vacuum chamber 42 is made higher than that of the vacuum chamber 22.

Then, as shown in Fig. 2, the take up roller 30 is rotated in a counterclockwise direction by the electrical motor 92. As a result, the take up reel 31 set on the take up roller 30 is rotationally driven, and the resin film 12 is started to be taken up. While the resin film 12 is gradually unwound from the roll 58 disposed on the periphery of the feeding roller 28, the first to third rollers 32, 34, and 36 over which the resin film 12 is wound are each rotated in a direction represented by arrows in Fig. 2. As a result, the resin film 12 unwound from the roll 58 passes over the first roller 32, the second roller 34, the third roller 36, and the take up roller 30 in the order of the description.

At the same time, the first deposition material 38a is heated by the first heater 40a and evaporated, thereby performing a vacuum vapor deposition. Accordingly, at a periphery of the first roller 32, the first electrode film 14 is formed on the one surface of the resin film 12 wound on the first roller 32. Then, the part of the resin film 12, on which the first electrode film 14 is formed, is sent to the second roller 34, which is positioned at a downstream side in a traveling direction of the resin film 12.

Diisocyanate and diamine, which are raw material or monomers, contained in the respective monomer input pots 52a, 52b are heated by the third heater 54a and the fourth heater 54b so as to be evaporated in the first auxiliary vacuum chamber 42. By causing the polymerization reaction of the diisocyanate and diamine on the first electrode film 14, which is formed on the one surface of the resin film 12 and exposed to the inside of the first auxiliary vacuum chamber 42, the first dielectric film 18 consisted by a polyurea resin film is formed on the first electrode film 14. Then, the part of the resin film 12 on which the first electrode film 14 and the first dielectric film 18 are formed is sent to the third roller 36 positioned at the downstream side.

Subsequently, before the resin film 12 sent from the second roller 34 reaches the third roller 36, plasma generated by the first plasma generator 56, which is positioned between the second roller 34 and the third roller 36, is applied onto the first dielectric film 18, thereby performing a plasma treatment on the first dielectric film 18. As a result, a three-dimensional cross-linked structure is introduced to the first dielectric film 18. Therefore, withstand voltage of the first dielectric film 18 can be effectively improved.

Then, the second deposition material 38b is heated by the second heater 40b and evaporated, thereby performing a vacuum evaporation. Consequently, at a periphery of the third roller 36, the second electrode film 16 is formed on a part of the other surface of the resin film 12 that is wound on the third roller 36, i.e., on the surface opposite to the surface on which the first electrode 14 and the first dielectric film 18 are formed. In this way, the multilayer sheet 10 including the first electrode film 14 and the first dielectric film 18, which are formed on one surface of the resin film 12, and the second electrode film 16, which is formed on the other surface of the resin film 12, is obtained, and the multilayer sheet 10 is sent to the take up roller 30 positioned at the downstream side.

Then, the multilayer sheet 10 is taken up by the take up reel 31 set on the take up roller 30. Accordingly, the intended multilayer sheet 10 is continuously formed and obtained in a form of roll.

Although not shown in the drawings, the multilayer sheet 10 is unwound from the obtained roll of the multilayer sheet 10 and cut in a predetermined length, for example. Then, cut pieces of the multilayer sheet 10 are stacked such that the second electrode film 16 and the first dielectric film 18 are stacked with each other, thereby producing a stacked film capacitor. Alternatively, while or after the multilayer sheet 10 is unwound from the roll of the multilayer sheet 10, the unwound multilayer sheet 10 is wound one time or a plurality of times such that the first dielectric film 18 faces inwardly, thereby producing a wound film capacitor.

As apparent from the above, in the present embodiment, the first metal vapor deposition means is constituted by the first deposition material 38a and the first heater 40a, and the second metal vapor deposition means is constituted by the second deposition material 38b and the second heater 40b. Further, the vapor deposition polymerization means is constituted by the two monomer input pots 52a, 52b and the third and fourth heaters 54a, 54b.

In the present embodiment, the metal vapor deposition process, in which the first and second electrode films 14, 16 are formed on the resin film 12, and the vapor deposition polymerization process, in which the first dielectric film 18 is formed on the resin film 12, are commenced simultaneously. Thus, the center of the roll, which is taken up by the take up roller 30, includes a portion in which only the first dielectric film 18 is formed on the one surface of the resin film 12 and a portion in which nothing is formed on the one surface of the resin film 12 while the second electrode film 16 is formed on the other surface of the resin film 12. However, these portions will be cut off eventually.

As described above, in the present embodiment, in one vacuum chamber 22, the first electrode film 14 and the first dielectric film 18 are formed in layers on one surface of the resin film 12, and the second electrode film 16 is formed on the other surface of the resin film 12, at a periphery of each of the first to third rollers 32, 34, and 36, while the resin film 12 wound over the first to third rollers 32, 34, and 36 is traveled in one direction between the feeding roller 28 and the take up roller 30.

Thus, according to the present embodiment, there is no need to prepare two separate apparatuses, i.e., an apparatus for continuously forming the first electrode film 14 and the second electrode film 16 on each surface of the resin film 12 by metal vapor deposition, and an apparatus for forming the dielectric film 18 further on the first electrode film 14 formed on one surface of the resin film 12 by vapor deposition polymerization. Consequently, there is also no need to set the metallized film in the apparatus again in order to form the first dielectric film 18 by vapor deposition polymerization on the first electrode film 14, after removing the metallized film including the resin film 12, and the first and second electrode films 14, 16 formed on the respective surfaces of the resin film 12, from the metal vapor deposition apparatus. Further, in the above operation, there is no need to control the pressure in the apparatuses separately so as to be in a vacuum state or an open-to-air condition.

Therefore, according to the present embodiment, the multilayer sheet 10 including the first and second electrode films 14, 16 formed on respective surfaces of the resin film 12 and the first dielectric film 18 formed on the first electrode film 14 by the vapor deposition polymerization can be advantageously produced at a sufficiently low cost with an excellent productivity. Consequently, a wound or stacked film capacitor formed by winding or stacking the multilayer sheet(s) 10 can be produced at a low cost with an excellent productivity.

In addition, according to the present embodiment, the first dielectric film 18 is formed on the first electrode film 14 by vapor deposition polymerization in the first auxiliary vacuum chamber 42 that is controlled so as to have a pressure different from the vacuum chamber 22. As a result, the vapor deposition polymerization which is performed under a different vacuum state than the metal vapor deposition can be performed under a proper condition in the vacuum chamber 22, which is adapted to perform metal polymerization. Thus, the first dielectric film 18 having a proper thickness and high quality can be advantageously formed on the first electrode film 14.

Then, the film capacitor according to the present invention is distinct from the conventional wound capacitor and the conventional multilayer capacitor that have only a structure (A), in which the first electrode film 14 and the second electrode film 16 are positioned on respective sides of the resin film 12 made of a stretched film or the like with the resin film 12 interposed therebetween. In addition to the structure (A), the film capacitor according to the present application has a structure (B) in which the first electrode film 14 and the second electrode film 16 are positioned on respective sides of the first dielectric film 18 which is formed of a vapor-deposited polymer film with the first dielectric film 18 interposed therebetween. In the structure (B), thickness of the first dielectric film 18 can be controlled on a nanoscale, because the first dielectric film 18 is formed by vapor deposition polymerization in a vacuum. Therefore, the thickness of the first dielectric film 18 is made extremely small and uniform, and the amount of impurities in the first dielectric film 18 is sufficiently reduced.

Accordingly, unlike the conventional film capacitor, a film capacitor obtained by using the multilayer sheet 10 formed according to the present invention can effectively be made smaller and have increased capacitance, without extremely reducing the thickness of the resin film 12 or without reducing the impurities in the material of the film.

Thus, the film capacitor obtained by using the multilayer sheet 10 formed in the present embodiment can be made smaller and can advantageously have increased capacity, without improving the functionality of the resin film 12 by reducing the thickness of the resin film 12 and reducing the impurities in the film material, and further without causing the problems which will be caused by reducing the thickness of the resin film 12. Therefore, various required performance can be obtained effectively.

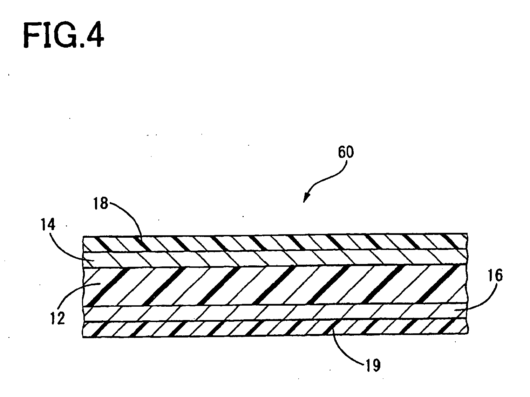

Then, Fig. 4 shows another embodiment of the multilayer sheet formed by the production apparatus according to the present invention, in a vertical cross sectional view. As apparent from Fig. 4, a multilayer sheet 60 includes the resin film 12, the first electrode film 14, which is a first vapor-deposited metal film, formed on one surface of the resin film 12, the second electrode film 16, which is a second vapor-deposited metal film, formed on the other surface of the resin film 12, the first dielectric film 18, which is a first vapor-deposited polymer film, formed on the first electrode film 14, and a second dielectric film 19, which is a second vapor-deposited polymer film, formed on the second electrode film 16.

The first and second electrode films 14, 16 of the above multilayer sheet 60 are made of the same material and have the same thickness and structure as the first and second electrode films 14, 16 of the multilayer sheet 10 formed by the film-forming apparatus 20 of the first embodiment. Further, the first and second dielectric films 18, 19 are made of the same material and have the same thickness and structure as the first dielectric film 18 of the multilayer sheet 10 formed by the apparatus of the first embodiment.

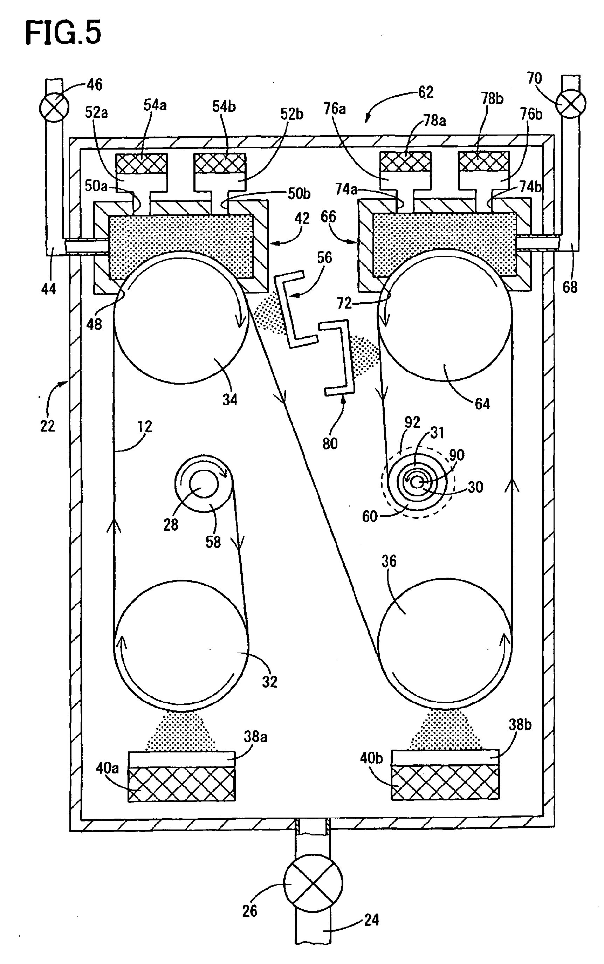

In the formation of the multilayer sheet 60, an apparatus for producing a multilayer sheet, or film-forming apparatus 62 (deposition apparatus) that has a structure shown in Fig. 5 is used, for example.

The film-forming apparatus 62 of the present embodiment includes a fourth roller 64, in addition to the first to third rollers 32, 34 and 36, in the vacuum chamber 22 of the apparatus 20 according to the first embodiment. The fourth roller 64 has the same outer diameter as the first to third rollers 32, 34 and 36. The fourth roller 64 is disposed in the vacuum chamber 22 at a position opposite to the third roller 36 in the longitudinal direction of the vacuum chamber 22 with the take up roller 30 disposed therebetween.

Further, a second auxiliary vacuum chamber 66 is disposed at a position opposite to the take up roller 30 with the fourth roller 64 interposed therebetween. To the second auxiliary vacuum chamber 66, a second auxiliary exhaust pipe 68 that extends from the outside of the vacuum chamber 22 through a side wall of the vacuum chamber 22 is connected. Further, a second auxiliary vacuum pump 70 is connected to the second auxiliary exhaust pipe 68 at a protruding portion thereof which extends from the vacuum chamber 22 to the outside. Furthermore, a window 72 is formed in a side wall of the second auxiliary vacuum chamber 66. Through the window 72, an outer surface of a part of the fourth roller 64 is exposed to the inside of the second auxiliary vacuum chamber 66.

The second auxiliary vacuum pump 70 is operated separately from the vacuum pump 26, so that the inside of the second auxiliary vacuum chamber 66 has a pressure different from the inside of the vacuum chamber 22. As apparent from this, in the present embodiment, the second auxiliary exhaust means is constituted by the second auxiliary vacuum pipe 68 and the second auxiliary vacuum pump 70. Here, operation of the second auxiliary vacuum pump 70 is controlled by the same controlling device for the first auxiliary vacuum pump 46. Due to the operation of the second auxiliary vacuum pump 70, the inside of the second auxiliary vacuum chamber 66 is in the vacuum state having the same pressure as the inside of the first auxiliary vacuum chamber 42.

Further, in a side wall of the second auxiliary vacuum chamber 66, two openings 74a, 74b are formed. Then, two monomer input pots 76a, 76b are connected through the respective openings 74a, 74b. In one of the two monomer input pots 76a, 76b, a predetermined amount of diisocyanate is contained. In the other one of the two monomer input pots 74a, 74b, a predetermined amount of diamine is contained. Further, a fifth heater 78a and a sixth heater 78b for heating a raw material or monomer in each of the monomer input pots 76a, 76b are provided on the respective monomer input pots 76a, 76b at the side opposite to the openings of the second auxiliary vacuum chamber 66. It is to be understood that the monomers in the monomer input pots 76a, 76b are suitably changed depending on kinds of polymer providing the second dielectric film 19 formed by vapor deposition polymerization.

In addition, between the fourth roller 64 and the take up roller 30 in the vacuum chamber 22, a second plasma generator 80 as the plasma treatment means is disposed so as to be positioned close to the fourth roller 64. The second plasma generator 80 has the same structure as the first plasma generator 56, as the first plasma treatment means, which is disposed close to the second roller 34.

In the formation of the multilayer sheet 60 by using the film-forming apparatus 62 according to the present embodiment, the procedure described below is followed, for example.

Initially, a part of the resin film 12 unwound from the roll 58 of the resin film 12, which is disposed outwardly of the feeding roller 28, is wound on the first to third rollers 32, 34, and 36 as in the first embodiment, and the part of the resin film 12 sent from the third roller 36 is wound on the fourth roller 64 such that the other surface of the resin film 12 is not contacted with the periphery of the fourth roller 64 and is exposed to the inside of the second auxiliary vacuum chamber 66. Further, the part of the resin film 12 sent from the fourth roller 64 is wound over a take up reel 31 set on the take up roller 30, thereby being releasably fixed.

Then, in the above state, the vacuum pump 26 and the first and second auxiliary vacuum pumps 46, 70 are operated. By the operation, the pressure in the vacuum chamber 22 is reduced to about 10⁻⁴ to 100 Pa, the pressure in the first auxiliary vacuum chamber 42 is reduced to about 10⁻⁵ to 10 Pa, and the pressure in the second auxiliary vacuum chamber 66 is reduced to about 10⁻⁵ to 10 Pa. Accordingly, inside of each of the vacuum chambers 22, 42, and 66 is in a vacuum state. Preferably, the degree of vacuum in the respective vacuum chambers 42, 66 is made higher than that of the vacuum chamber 22.

Then, as shown in Fig. 5, the take up roller 30 is rotated in a counterclockwise direction by the electrical motor 92. By this rotation, the feeding roller 28 and the first to fourth rollers 32, 34, 36, and 64 are rotated in a direction represented by arrows in Fig. 5, and the resin film 12 is gradually unwound from the roll 58 disposed outwardly of the feeding roller 28, while the unwound resin film 12 is taken up by the take up roller 30. Then, the resin film 12 unwound from the roll 58 passes over the first roller 32, the second roller 34, the third roller 36, the fourth roller 64 and the take up roller 30 in the order of the description.

Like the first embodiment, when the resin film 12 passes over the first roller 32, the second roller 34, the third roller 36, and the take up roller 30 in the order of the description, on the periphery of each of the rollers 32, 34, and 36, the first electrode film 14 and the first dielectric film 18 are formed in layers on one surface of the dielectric film and the second electrode film 16 is formed on the other surface of the resin film 12. In this embodiment, when a part of the resin film 12 on which the first electrode film 14 and the first dielectric film 18 are formed in layers is sent from the second roller 34 to the third roller 36, in the middle thereof, plasma treatment by the first plasma generator 56 is performed on the first dielectric film 18 which is formed on the part of the resin film 12, thereby introducing the three-dimensional cross-linked structure to the first dielectric film 18. Accordingly, the withstand voltage of the first dielectric film 18 is improved.

Then, in the second auxiliary vacuum chamber 66, on the second electrode film 16 of the resin film 12 which is wound on the fourth roller 64, the second dielectric film 19 is formed. The second dielectric film 19 is formed in the second auxiliary vacuum chamber 66 by the vapor deposition polymerization that is similar to the one performed when the first dielectric film 18 is formed on the first electrode film 14 of the resin film 12 in the first auxiliary vacuum chamber 42.

In this way, the multilayer sheet 60 including the first electrode film 14 and the first dielectric film 18, which are formed on one surface of the resin film 12, and the second electrode film 16 and the second dielectric film 19, which are formed on the other surface of the resin film 12, is obtained, and the multilayer sheet 60 is sent toward the take up roller 30 positioned at the downstream side.

Subsequently, before the resin film 12 sent from the fourth roller 64 reaches the take up roller 30, plasma generated by the second plasma generator 80 positioned between the fourth roller 64 and the take up roller 30 is applied onto the surface of the second dielectric film 19, thereby performing a plasma treatment on the second dielectric film 19. As a result, a three-dimensional cross-linked structure is introduced to the second dielectric film 19. Therefore, withstand voltage of the second dielectric film 19 can be effectively improved.

Then, the multilayer sheet 60 including the second dielectric film 19 subjected to a plasma treatment is taken up to the take up reel 31 by the take up roller 30. Accordingly, the intended multilayer sheet 60 is continuously produced and obtained in a form of roll.

Then, the multilayer sheet 60 is unwound from the roll of the obtained multilayer sheet 60, and a stacked or wound film capacitor is produced like the above.

As apparent from the above, in the present embodiment, the first metal vapor deposition means is constituted by the first deposition material 38a and the first heater 40a, and the second metal vapor deposition means is constituted by the second deposition material 38b and the second heater 40b. Further, the first vapor deposition polymerization means is constituted by the monomer input pots 52a, 52b and the third and fourth heaters 54a, 54b, and the second vapor deposition polymerization means is constituted by the monomer input pots 76a, 76b and the fifth and sixth heaters 78a, 78b.

As described above, according to the present embodiment, in one vacuum chamber 22, the first electrode film 14 and the first dielectric film 18 are formed on one surface of the resin film 12, and the second electrode film 16 and the second dielectric film 19 are formed on the other surface of the resin film 12, at a periphery of each of the first to fourth rollers 32, 34, 36, and 64, while the resin film 12 wound on the first to third rollers 32, 34, 36, and 64 is traveled in one direction between the feeding roller 28 and the take up roller 30.

Thus, according to the present embodiment, there is no need to prepare two separate apparatus, i.e., an apparatus for continuously forming the first electrode film 14 and the second electrode film 16 on each surface of the resin film 12 by metal vapor deposition, and an apparatus for forming the dielectric film 18 and the second dielectric film 19 further on the first electrode film 14 and the second electrode film 16 by vapor deposition polymerization. Consequently, there is also no need to set the metallized film in the apparatus again in order to form the first dielectric film 18 and the second dielectric film 19 on the first electrode film 14 and the second electrode film 16, respectively, by vapor deposition polymerization, after removing the metallized film including the resin film 12 and the first and second electrode films 14, 16 formed on the respective surfaces of the resin film 12, from the metal vapor deposition apparatus. Further, in the above operation, there is no need to control the pressure in the apparatuses separately so as to be in a vacuum state or an open-to-air condition in the above operation.

Therefore, according to the present embodiment, the multilayer sheet 60 including the first and second electrode films 14, 16 formed on respective surfaces of the resin film 12 and the first and second dielectric films 18, 19 formed on the first and second electrode films 14, 16, respectively, by vapor deposition polymerization can be advantageously produced at a sufficiently low cost with an excellent productivity. As a result, a stacked or wound film capacitor can be formed at a low cost with an excellent productivity. Further, in the production of the film capacitor, the same advantages and effects as the first embodiment can be advantageously obtained.

While the specific embodiments of the present invention has been described in detail, for illustrative purpose only, it is to be understood that the present invention is not limited to the details of the illustrated embodiments.

For example, in the first embodiment, although the first dielectric film (the first vapor-deposited polymer film) 18 is formed only on an outer surface of the first electrode film (the first vapor-deposited metal film) 14, at the side opposite to the resin film 12, the first dielectric film 18 can be formed only on an outer surface of the second electrode film (the second vapor-deposited metal film) 16, instead of the first electrode film 14, at the side opposite to the resin film 12.

Further, in the first and second embodiments, although all of the first to fourth rollers 32, 34, 36, and 64 is adapted to have the same outer diameter, at least one of them may have a different diameter. If the vapor-deposited metal film or the vapor-deposited polymer film is formed on the resin film 12 at a periphery of the roller having a larger diameter than the other rollers, it can have a larger thickness, because metal vapor deposition or vapor deposition polymerization is performed for a longer time compared to the other rollers. On the other hand, if the vapor-deposited metal film and the vapor-deposited polymer film is formed on the resin film 12 at a periphery of the roller having a smaller diameter than the other rollers, it can have a smaller thickness, because metal vapor deposition or vapor deposition polymerization is performed for a shorter time compared to the other rollers.

In the formation of films, for example, when time required to have a predetermined thickness (time required for the metal vapor deposition operation or the vapor deposition polymerization operation) differs among films to be formed, it may be advantageous to make an outer diameter of some of the first to fourth rollers 32, 34, 36, and 64 different from each other. Specifically, when the outer diameter of the roller on which a film requiring a longer time to have a predetermined thickness is to be formed is made larger, or when the outer diameter of the roller on which a film requiring a shorter time to have a predetermined thickness is to be formed is made smaller, each of the films having a predetermined thickness can be advantageously and surely formed while the resin film 12 is traveled between the rollers 32, 34, 36, and 64 in a constant speed.

Further, in the first and second embodiments, the resin film 12 is adapted to be traveled from the feeding roller 28 side to the take up roller 30 side by rotationally driving the take up roller 30 by driving means such as an electric motor. However, the driving means may rotationally drive at least one of the take up roller 30, the feeding roller 28, and the first to fourth rollers 32, 34, 36, and 64. Further, it is to be understood that any well known rotationally driving means other than the electric motor may be employed.

Furthermore, the film-forming apparatus 20, 62 may further comprise a rotational speed control mechanism which controls rotational speed of each of the rollers 28, 30, 32, 34, 36, and 64 rotated by the driving means (for example, if the driving means is an electric motor, a well known control mechanism that can control a rotational speed of the electric motor). By this rotational speed control mechanism, the traveling speed of the resin film 12 can be changed as appropriate. When the traveling speed of the resin film 12 is slow downed, a metal vapor deposition process and a vapor deposition polymerization process can be performed for a longer time. Accordingly, thickness of each of the first and second electrode films 14, 16 and the first and second dielectric films 18, 19 can be increased, for example. On the other hand, when the traveling speed of the resin film 12 is accelerated, a metal vapor deposition process or a vapor deposition polymerization process can be finished in a shorter time. Accordingly, thickness of each of the first and second electrode films 14, 16 and the first and second dielectric films 18, 19 can be decreased, for example.

Further, the film-forming apparatus 20, 62 may further comprise cooling means that cools the periphery of each of the first to fourth rollers 32, 34, 36, and 64, which results in cooling of the part of the resin film 12 disposed thereon. Accordingly, each of the electrode films 14, 16 and each of the dielectric film 18, 19, which are formed on the periphery of each of the rollers 32, 34, 36, and 64, can be effectively cooled to be stabilized.

Further, the film-forming apparatus 20, 62 may further comprise a distance control mechanism that changes a distance between the first roller 32 and the first vapor deposition material 38a, or a distance between the third roller 36 and the second vapor deposition material 38b. This distance control mechanism is constituted by a combination of an electric motor and a cam mechanism or a link mechanism, or various actuators such as a cylinder mechanism, for example. The distance control mechanism may have a structure that moves the first roller 32 or the third roller 36 closer to or away from the first vapor deposition material 38a or the second vapor deposition material 38b. Alternatively, the distance control mechanism may have a structure that moves the first vapor deposition material 38a or the second vapor deposition material 38b closer to or away from the first roller 32 or the third roller 36. Accordingly, thickness of each of the first electrode film 14 and the second electrode film 16 can be controlled.

In addition, the first to sixth heaters 40a, 40b, 54a, 54b, 78a, and 78b may have a control mechanism that can separately control the heating temperature of the heaters. By the control mechanism, the evaporation amount of the vapor deposition materials 38a, 38b and monomers can be controlled. Accordingly, metal vapor deposition or vapor deposition polymerization can be performed under more specifically controlled condition. Consequently, controls of the thickness and the like of the electrode films 14, 16 or the dielectric films 18, 19 can be advantageously and surely conducted, separately from the control of the outer diameter of the roller, the control by the distance control mechanism, and the control of degrees of vacuum (inner pressure) in the vacuum chamber 22 and the first and second auxiliary vacuum chambers 42, 66, or alternatively by a combination of the control mechanism and such controls.

In the second embodiment, the first auxiliary vacuum chamber 42 and the second auxiliary vacuum chamber 66 are separately constituted. Further, the first auxiliary vacuum pump 46 and the second auxiliary vacuum pump 70 are separately constituted. However, the first auxiliary vacuum chamber 42 and the second auxiliary vacuum chamber 66 may be constituted by one auxiliary vacuum chamber, and the first auxiliary vacuum pump 46 and the second auxiliary vacuum pump 70 may be constituted by one auxiliary vacuum pump. In this case, a part of the second roller 34 and a part of the fourth roller 64 are disposed so as to be exposed to the inside of the one auxiliary vacuum chamber. In the one auxiliary vacuum chamber, the first dielectric film 18 and the second dielectric film 19 are formed on the first electrode film 14 and the second electrode film 16, respectively.

In addition, the present invention is also advantageously applicable to an apparatus for producing a multilayer sheet that is used as a packing sheet and a protective sheet for various products, and to a method of producing the same, other than the apparatus for producing a multilayer sheet used to produce a film capacitor and a method of producing the same.

## Claims

1. An apparatus for producing a multilayer sheet comprising:
a vacuum chamber (22) including, in an inside thereof, a feeding roller (28) for unwinding a resin film (12) from a roll of the resin film, and a take up roller (30) for winding the resin film unwound from the roll;
exhaust means (24, 26) for exhausting atmosphere in the vacuum chamber, whereby the inside of the vacuum chamber is in a vacuum state;
a first roller (32) disposed in the vacuum chamber, the resin film unwound from the roll of the resin film by the feeding roller being wound on the first roller such that one surface of the resin film faces outwardly;
a second roller (34) disposed in the vacuum chamber, the resin film sent from the first roller being wound on the second roller such that the one surface of the resin film faces outwardly;
a third roller (36) disposed in the vacuum chamber, the resin film sent from the second roller being wound on the third roller such that the other surface of the resin film faces outwardly;
driving means (90, 92) rotary driving at least one of the feeding roller, the take up roller, the first roller, the second roller, and the third roller, thereby sending the resin film from the feeding roller side to the take up roller side;
first metal vapor deposition means (38a, 40a) for forming a first vapor-deposited metal film (14) on the one surface of the resin film, at a periphery of the first roller;
first vapor deposition polymerization means (52a, 52b, 54a, 54b) for forming a first vapor-deposited polymer film (18) on the first vapor-deposited metal film formed on the one surface of the resin film, at a periphery of the second roller; and
second metal vapor deposition means (38b, 40b) for forming a second vapor-deposited metal film (16) on the other surface of the resin film, at a periphery of the third roller,
whereby the multilayer sheet comprising the resin film, the first vapor-deposited metal film, the second vapor-deposited metal film and the first vapor-deposited polymer film is obtained.

2. The apparatus for producing a multilayer sheet according to claim 1, further comprising a first auxiliary vacuum chamber (42) disposed in the vacuum chamber and first auxiliary exhaust means (44, 46) operable separately from the exhaust means (24, 26), the first auxiliary vacuum chamber being adapted to contain a part of the one surface of the resin film (12) wound on the second roller (34) and the first auxiliary exhaust means being adapted to exhaust the atmosphere in the first auxiliary vacuum chamber such that the first auxiliary vacuum chamber has a different degree of vacuum from that of the vacuum chamber (22), thereby forming the first vapor-deposited polymer film (18) on the first vapor-deposited metal film (14) in the first auxiliary vacuum chamber by vapor deposition polymerization.

3. The apparatus for producing a multilayer sheet according to claim 1 or 2, further comprising first plasma treatment means (56) for introducing a three-dimensional cross-linked structure into the first vapor-deposited polymer film.

4. The apparatus for producing a multilayer sheet according to claim 1, further comprising:
a fourth roller (64) disposed in the vacuum chamber, the resin film sent from the third roller being wound on the fourth roller such that the other surface of the resin film faces outwardly; and
second vapor deposition polymerization means (76a, 76b, 78a, 78b) for forming a second vapor-deposited polymer film (19) by vapor deposition polymerization on the second vapor-deposited metal film (16) formed on the other surface of the resin film, at a periphery of the fourth roller,
wherein the driving means rotary drives at least one of the feeding roller, the take up roller, the first roller, the second roller, the third roller, and the fourth roller, thereby sending the resin film from the feeding roller side to the take up roller side,
whereby the multilayer sheet comprising the resin film, the first vapor-deposited metal film, the second vapor-deposited metal film, the first vapor-deposited polymer film and the second vapor-deposited polymer film is obtained.

5. The apparatus for producing a multilayer sheet according to claim 4, further comprising:
a first auxiliary vacuum chamber (42) and a second auxiliary vacuum chamber (66) in the vacuum chamber, the first auxiliary vacuum chamber being adapted to contain a part of the one surface of the resin film wound on the second roller, and the second auxiliary vacuum chamber being adapted to contain a part of the other surface of the resin film wound on the fourth roller; and
first auxiliary exhaust means (44, 46) and second auxiliary exhaust means (68, 70) operable separately from the exhaust means (24, 26), the first auxiliary exhaust means and the second auxiliary exhaust means being adapted to exhaust the atmosphere in the first auxiliary vacuum chamber and the second auxiliary vacuum chamber, respectively, such that each of the first auxiliary vacuum chamber and the second auxiliary vacuum chamber has a different degree of vacuum from that of the vacuum chamber, thereby forming the first vapor-deposited polymer film on the first vapor-deposited metal film in the first auxiliary vacuum chamber by the first vapor deposition polymerization means and the second vapor-deposited polymer film on the second vapor-deposited metal film in the second auxiliary vacuum chamber by the second vapor deposition polymerization means.

6. The apparatus for producing a multilayer sheet according to claim 4 or 5, further comprising first plasma treatment means (56) and second plasma treatment means (80) in the vacuum chamber, the first plasma treatment means introducing a three-dimensional cross-linked structure to the first vapor-deposited polymer film and the second plasma treatment means introducing a three-dimensional cross-linked structure into the second vapor-deposited polymer film.

7. The apparatus for producing a multilayer sheet according to any one of claims 1 to 6, wherein the multilayer sheet is used to produce a film capacitor.

8. A method of producing a multilayer sheet, comprising the steps of:
providing a deposition apparatus (20) including a vacuum chamber (22) having a first roller (32), a second roller (34), and a third roller (36) therein, in which a resin film (12) in the vacuum chamber is wound on the first roller, the second roller and the third roller in the order of the description;
traveling the resin film from the first roller side to the third roller side while the vacuum chamber is in a vacuum state, the resin film being wound on the first roller and the second roller such that one surface of the resin film faces outwardly and the resin film sent from the second roller being wound on the third roller such that the other surface thereof faces outwardly;
forming a first vapor-deposited metal film (14) on the one surface of the resin film at a periphery of the first roller;
forming a first vapor-deposited polymer film (18) on the first vapor-deposited metal film formed on the one surface of the resin film, at a periphery of the second roller; and
forming a second vapor-deposited metal film (16) on the other surface of the resin film, at a periphery of the third roller,
whereby the multilayer sheet comprising the resin film, the first vapor-deposited metal film, the second vapor-deposited metal film and the first vapor-deposited polymer film is obtained.

9. The method of producing a multilayer sheet according to claim 8, further comprising the step of treating the first vapor-deposited polymer film by plasma treatment, whereby a three-dimensional cross-linked structure is introduced to the first vapor-deposited polymer film.

10. A method of producing a film capacitor, comprising the step of winding the multilayer sheet obtained according to claim 8 or 9 at least one time, or stacking a plurality of multilayer sheets with each other.

11. The method of producing a film capacitor according to claim 10, wherein the first vapor-deposited polymer film is a polyurea resin film.

12. The method of producing a film capacitor according claim 10 or 11, wherein the first vapor-deposited polymer film has a higher dielectric constant than the resin film.

13. The method of producing a film capacitor according to any one of claims 10 to 12, wherein the first vapor-deposited polymer film is formed to have a thickness in a range of from 0.01 to 10 µm.

14. The method of producing a film capacitor according to any one of claims 10 to 13, wherein the resin film is formed of polypropylene, and the first vapor-deposited polymer film is formed of polyurea resin.

15. The method of producing a multilayer sheet according to claim 8, wherein the vacuum chamber further includes a fourth roller (64), and the resin film in the vacuum chamber is traveled from the first roller side to the fourth roller side while the resin film is further wound on the fourth roller such that the other surface thereof faces outwardly, thereby further forming a second vapor-deposited polymer film (19) on the second vapor-deposited metal film (14) formed on the other surface of the resin film (16), at a periphery of the fourth roller,
whereby the multilayer sheet comprising the resin film, the first vapor-deposited metal film, the second vapor-deposited metal film, the first vapor-deposited polymer film and the second vapor-deposited polymer film is obtained.

## Patentansprüche

1. Vorrichtung zum Herstellen einer Mehrschichtfolie, umfassend:
eine Vakuumkammer (22), die in ihrem Inneren eine Zufuhrwalze (28) zum Abwickeln eines Harzfilms (12) von einer Rolle des Harzfilms und eine Aufwickelwalze (30) zum Aufwickeln des von der Rolle abgewickelten Harzfilms umfasst;
Auspumpmittel (24, 26) zum Auspumpen von Atmosphäre in der Vakuumkammer, wodurch das Innere der Vakuumkammer sich in einem Vakuumzustand befindet;
eine erste Walze (32), die in der Vakuumkammer angeordnet ist, wobei der durch die Zufuhrwalze abgegebene, von der Rolle des Harzfilms abgewickelte Harzfilm auf die erste Walze aufgewickelt wird, so dass eine Fläche des Harzfilms nach außen gewandt ist;
eine zweite Walze (34), die in der Vakuumkammer angeordnet ist, wobei der von der ersten Walze geleitete Harzfilm auf die zweite Walze aufgewickelt wird, so dass die eine Fläche des Harzfilms nach außen gewandt ist;
eine dritte Walze (36), die in der Vakuumkammer angeordnet ist, wobei der von der zweiten Walze geleitete Harzfilm auf die dritte Walze aufgewickelt wird, so dass die andere Fläche des Harzfilms nach außen gewandt ist;
Antriebsmittel (90, 92), die zumindest eine von der Zufuhrwalze, der Aufwickelwalze, der ersten Walze, der zweiten Walze und der dritten Walze rotatorisch antreiben und dadurch den Harzfilm von der Zufuhrwalzenseite zur Aufwickelwalzenseite leiten;
erste Metallaufdampfmittel (38a, 40a) zum Bilden eines ersten aufgedampften Metallfilms (14) auf der einen Fläche des Harzfilms an einem Umfang der ersten Walze;
erste Aufdampfpolymerisationsmittel (52a, 52b, 54a, 54b) zum Bilden eines ersten aufgedampften Polymerfilms (18) auf dem ersten auf der einen Fläche des Harzfilms an einem Umfang der zweiten Walze gebildeten aufgedampften Metallfilm; und
zweite Metallaufdampfmittel (38b, 40b) zum Bilden eines zweiten aufgedampften Metallfilms (16) auf der anderen Fläche des Harzfilms an einem Umfang der dritten Walze;
wodurch die Mehrschichtfolie, die den Harzfilm, den ersten aufgedampften Metallfilm, den zweiten aufgedampften Metallfilm und den ersten aufgedampften Po-lymerfilm umfasst, erhalten wird.

2. Vorrichtung zum Herstellen einer Mehrschichtfolie nach Anspruch 1, wobei diese ferner eine erste Hilfsvakuumkammer (42), die in der Vakuumkammer angeordnet ist, und ein erstes Hilfsauspumpmittel (44, 46) umfasst, das separat vom Auspumpmittel (24, 26) betätigbar ist, wobei die erste Hilfsvakuumkammer dazu geeignet ist, einen Teil der einen Fläche des auf die zweite Walze (34) aufgewickelten Harzfilms (12) zu enthalten, und das erste Hilfsauspumpmittel dazu geeignet ist, die Atmosphäre in der ersten Hilfsvakuumkammer derart auszupumpen, dass die erste Hilfsvakuumkammer einen anderen Vakuumgrad aufweist als die Vakuumkammer (22), wodurch in der ersten Hilfsvakuumkammer durch Aufdampfpolymerisation der erste aufgedampfte Polymerfilm (18) auf dem ersten aufgedampften Metallfilm (14) gebildet wird.

3. Vorrichtung zum Herstellen einer Mehrschichtfolie nach Anspruch 1 oder 2, wobei diese ferner ein erstes Plasmabehandlungsmittel (56) zum Einbringen einer dreidimensionalen quervernetzten Struktur in den ersten aufgedampften Polymerfilm umfasst.

4. Vorrichtung zum Herstellen einer Mehrschichtfolie nach Anspruch 1, wobei diese ferner Folgendes umfasst:
eine vierte Walze (64), die in der Vakuumkammer angeordnet ist, wobei der von der dritte Walze geleitete Harzfilm auf die vierte Walze aufgewickelt wird, so dass die andere Fläche des Harzfilms nach außen gewandt ist; und
zweite Dampfablagerungspolymerisationsmittel (76a, 76b, 87a, 87b) zum Bilden eines zweiten aufgedampften Polymerfilms (19) durch Aufdampfpolymerisation auf dem zweiten auf der anderen Fläche des Harzfilms an einem Umfang der vierten Walze gebildeten aufgedampften Metallfilm (16),
worin das Antriebsmittel zumindest eine von der Zufuhrwalze, der Aufwickelwalze, der ersten Walze, der zweiten Walze, der dritten Walze und der vierten Walze rotatorisch antreibt und dadurch den Harzfilm von der Zufuhrwalzenseite zur Aufwickelwalzenseite leitet,
wodurch die Mehrschichtfolie, die den Harzfilm, den ersten aufgedampften Metallfilm, den zweiten aufgedampften Metallfilm, den ersten aufgedampften Polymerfilm und den zweiten aufgedampften Polymerfilm umfasst, erhalten wird.

5. Vorrichtung zum Herstellen einer Mehrschichtfolie nach Anspruch 4, wobei diese ferner Folgendes umfasst:
eine erste Hilfsvakuumkammer (42) und eine zweite Hilfsvakuumkammer (66) in der Vakuumkammer, wobei die erste Hilfsvakuumkammer dazu geeignet ist, einen Teil der einen Fläche des auf die zweite Walze aufgewickelten Harzfilms zu enthalten, und die zweite Hilfsvakuumkammer dazu geeignet ist, einen Teil der anderen Fläche des auf die vierte Walze aufgewickelten Harzfilms zu enthalten; und
erste Hilfsauspumpmittel (44, 46) und zweite Hilfsauspumpmittel (68, 70), die separat vom Auspumpmittel (24, 26) betätigbar sind, wobei das erste Hilfsauspumpmittel und das zweite Hilfsauspumpmittel dazu geeignet sind, jeweils die Atmosphäre in der ersten Hilfsvakuumkammer bzw. in der zweiten Hilfsvakuumkammer derart auszupumpen, dass die erste Hilfsvakuumkammer und die zweite Hilfsvakuumkammer jeweils einen anderen Vakuumgrad aufweisen als die Vakuumkammer, wodurch in der ersten Hilfsvakuumkammer durch das erste Aufdampfpolymerisationsmittel der erste aufgedampfte Polymerfilm auf dem ersten aufgedampften Metallfilm gebildet wird und in der zweiten Hilfsvakuumkammer durch das zweite Aufdampfpolymerisationsmittel der zweite aufgedampfte Polymerfilm auf dem zweiten aufgedampften Metallfilm gebildet wird.

6. Vorrichtung zum Herstellen einer Mehrschichtfolie nach Anspruch 4 oder 5, wobei diese ferner erste Plasmabehandlungsmittel (56) und zweite Plasmabehandlungsmittel (80) in der Vakuumkammer umfasst, wobei die erste Plasmabehandlung bedeutet, dass eine dreidimensionale quervernetzte Struktur in den ersten aufgedampften Polymerfilm eingebracht wird, und die zweite Plasmabehandlung bedeutet, dass eine dreidimensionale quervernetzte Struktur in den zweiten aufgedampften Polymerfilm eingebracht wird.

7. Vorrichtung zum Herstellen einer Mehrschichtfolie nach einem der Ansprüche 1 bis 6, worin die Mehrschichtfolie verwendet wird, um einen Filmkondensator herzustellen.

8. Verfahren zum Herstellen einer Mehrschichtfolie, wobei das Verfahren folgende Schritte umfasst:
Bereitstellen einer Aufdampfvorrichtung (20), die eine Vakuumkammer (22) mit einer ersten Walze (32), einer zweiten Walze (34) und einer dritten Walze (36) umfasst, in der ein Harzfilm (12) in der Vakuumkammer in der hier beschriebenen Reihenfolge auf die erste Walze, die zweite Walze und die dritte Walze aufgewickelt wird;
Bewegen des Harzfilms von der ersten Walzenseite zur dritten Walzenseite, während die Vakuumkammer sich in einem Vakuumzustand befindet, wobei der Harzfilm auf die erste Walze und die zweite Walze derart aufgewickelt wird, dass eine Fläche des Harzfilms nach außen gewandt ist, und der von der zweiten Walze geleitete Harzfilm auf die dritte Walze derart aufgewickelt wird, dass seine andere Fläche nach außen gewandt ist;
Ausbilden eines ersten aufgedampften Metallfilms (14) auf der einen Fläche des Harzfilms an einem Umfang der ersten Walze;
Ausbilden eines ersten aufgedampften Polymerfilms auf dem ersten aufgedampften Metallfilm, der auf einer Fläche des Harzfilms an einem Umfang der ersten Walze ausgebildet ist; und
Ausbilden eines zweiten aufgedampften Metallfilms (16) auf der anderen Fläche des Harzfilms an einem Umfang der dritten Walze,
wodurch die Mehrschichtfolie, die den Harzfilm, den ersten aufgedampften Metallfilm, den zweiten aufgedampften Metallfilm und den ersten aufgedampften Polymerfilm umfasst, erhalten wird.

9. Verfahren zum Herstellen einer Mehrschichtfolie nach Anspruch 8, wobei dieses ferner den Schritt des Behandelns des ersten aufgedampften Polymerfilms durch Plasmabehandlung umfasst, wodurch eine dreidimensionale quervernetzte Struktur in den ersten aufgedampften Polymerfilm eingebracht wird.

10. Verfahren zum Herstellen eines Filmkondensators, der den Schritt des zumindest einmaligen Aufwickelns der nach Anspruch 8 oder 9 erhaltenen Mehrschichtfolie oder des Stapelns einer Vielzahl von Mehrschichtfolien aufeinander umfasst.

11. Verfahren zum Herstellen eines Filmkondensators nach Anspruch 10, worin der erste aufgedampfte Polymerfilm ein Polyharnstoffharzfilm ist.

12. Verfahren zum Herstellen eines Filmkondensators nach Anspruch 10 oder 11, worin der erste aufgedampfte Polymerfilm eine höhere dielektrische Konstante besitzt als der Harzfilm.

13. Verfahren zum Herstellen eines Filmkondensators nach einem der Ansprüche 10 bis 12, worin der erste aufgedampfte Polymerfilm so ausgebildet ist, dass er eine Dicke in einem Bereich von 0,01 bis 10 µm aufweist.

14. Verfahren zum Herstellen eines Filmkondensators nach einem der Ansprüche 10 bis 13, worin der Harzfilm aus Polypropylen ausgebildet ist und der erste aufgedampfte Polymerfilm aus Polyharnstoffharz ausgebildet ist.

15. Verfahren zum Herstellen einer Mehrschichtfolie nach Anspruch 8, worin die Vakuumkammer ferner eine vierte Walze (64) umfasst und der Harzfilm in der Vakuumkammer von der ersten Walzenseite zur vierten Walzenseite bewegt wird, während der Harzfilm weiter auf die vierte Walze aufgewickelt wird, so dass seine andere Fläche nach außen gewandt ist, wodurch ferner auf einem Umfang der vierten Walze ein zweiter aufgedampfter Polymerfilm (19) auf dem auf der anderen Fläche des Harzfilms (16) gebildeten zweiten aufgedampften Metallfilm (14) gebildet wird,
wodurch die Mehrschichtfolie, die den Harzfilm, den ersten aufgedampften Metallfilm, den zweiten aufgedampften Metallfilm, den ersten aufgedampften Polymerfilm und den zweiten aufgedampften Polymerfilm umfasst, erhalten wird.

## Revendications

1. Appareil de production d'une feuille multicouche, comprenant :
une chambre à vide (22) incluant, dans son intérieur, un rouleau d'amenée (28) pour dérouler un film de résine (12) d'un rouleau du film de résine, et un rouleau d'enroulement (30) pour enrouler le film de résine déroulé du rouleau ;
des moyens d'évacuation (24, 26) pour évacuer l'atmosphère dans la chambre à vide, moyennant quoi l'intérieur de la chambre à vide se trouve dans un état de vide ;
un premier rouleau (32) disposé dans la chambre à vide, le film de résine déroulé du rouleau de film de résine par le rouleau d'amenée étant enroulé sur le premier rouleau de telle sorte qu'une surface du film de résine soit orientée vers l'extérieur ;
un deuxième rouleau (34) disposé dans la chambre à vide, le film de résine envoyé par le premier rouleau étant enroulé sur le deuxième rouleau de telle sorte que la surface précitée du film de résine soit orientée vers l'extérieur ;
un troisième rouleau (36) disposé dans la chambre à vide, le film de résine envoyé du deuxième rouleau étant enroulé sur le troisième rouleau de telle sorte que l'autre surface du film de résine soit orientée vers l'extérieur ;
des moyens d'entraînement (90, 92) entraînant en rotation au moins un du rouleau d'amenée, du rouleau d'enroulement, du premier rouleau, du deuxième rouleau et du troisième rouleau, en envoyant ainsi le film de résine du côté du rouleau d'amenée au côté du rouleau d'enroulement ;
des premiers moyens de dépôt en phase vapeur métallique (38a, 40a) pour former un premier film métallique déposé en phase vapeur (14) sur la surface précitée du film de résine, à une périphérie du premier rouleau ;
des premiers moyens de polymérisation de dépôt en phase vapeur (52a, 52b, 54a, 54b) pour former un premier film de polymère déposé en phase vapeur (18) sur le premier film métallique déposé en phase vapeur formé sur la surface précité du film de résine, à une périphérie du deuxième rouleau ; et
des deuxième moyens de dépôt en phase vapeur métallique (38b, 40b) pour former un deuxième film métallique déposé en phase vapeur (16) sur l'autre surface du film de résine, à une périphérie du troisième rouleau,
moyennant quoi la feuille multicouche comprenant le film de résine, le premier film métallique déposé en phase vapeur, le deuxième film métallique déposé en phase vapeur et le premier film de polymère déposé en phase vapeur est obtenue.

2. Appareil de production d'une feuille multicouche selon la revendication 1, comprenant en outre une première chambre à vide auxiliaire (42) disposée dans la chambre à vide, et de premiers moyens d'évacuation auxiliaires (44, 46) actionnables séparément des moyens d'évacuation (24, 26), la première chambre à vide auxiliaire étant apte à contenir une partie de la surface précitée du film de résine (12) enroulée sur le deuxième rouleau (34), et les premiers moyens d'évacuation auxiliaires étant aptes à évacuer l'atmosphère dans la première chambre à vide auxiliaire de telle sorte que la première chambre à vide auxiliaire présente un degré de vide différent de celui de la chambre à vide (22), en formant ainsi le premier film de polymère déposé en phase vapeur (18) sur le premier film métallique déposé en phase vapeur (14) dans la première chambre à vide auxiliaire par polymérisation de dépôt en phase vapeur.

3. Appareil de production d'une feuille multicouche selon la revendication 1 ou 2, comprenant en outre un premier moyen de traitement au plasma (56) pour introduire une structure tridimensionnelle réticulée dans le premier film de polymère déposé en phase vapeur.

4. Appareil de production d'une feuille multicouche selon la revendication 1, comprenant en outre :
un quatrième rouleau (64) disposé dans la chambre à vide, le film de résine transmis du troisième rouleau étant enroulé sur le quatrième rouleau de telle sorte que l'autre surface du film de résine soit orientée vers l'extérieur ; et
des deuxième moyens de polymérisation de dépôt en phase vapeur (76a, 76b, 78a, 78b) pour former un deuxième film de polymère déposé en phase vapeur (19) par polymérisation de dépôt en phase vapeur sur le deuxième film métallique déposé en phase vapeur (16) formé sur l'autre surface du film de résine, à une périphérie du quatrième rouleau,
où le moyen d'entraînement entraîne en rotation au moins un parmi le rouleau d'amenée, le rouleau d'enroulement, le premier rouleau, le deuxième rouleau, le troisième rouleau et le quatrième rouleau, en envoyant ainsi le film de résine du côté du rouleau d'amenée au côté du rouleau d'enroulement,
moyennant quoi la feuille multicouche comprenant le film de résine, le premier film métallique déposé en phase vapeur, le deuxième film métallique déposé en phase vapeur, le premier film de polymère déposé en phase vapeur et le deuxième film de polymère déposé en phase vapeur est obtenue.

5. Appareil de production d'une feuille multicouche selon la revendication 4, comprenant en outre :
une première chambre à vide auxiliaire (42) et une deuxième chambre à vide auxiliaire (66) dans la chambre à vide, la première chambre à vide auxiliaire étant apte à contenir une partie de la surface précitée du film de résine enroulé sur le deuxième rouleau, et la deuxième chambre à vide auxiliaire étant apte à contenir une partie de l'autre surface du film de résine enroulé sur le quatrième rouleau ; et
les premiers moyens d'évacuation auxiliaires (44, 46) et les deuxièmes moyens d'évacuation auxiliaires (68, 70) étant actionnables séparément des moyens d'évacuation (24, 26), les premiers moyens d'évacuation auxiliaires et les deuxièmes moyens d'évacuation auxiliaires étant aptes à évacuer l'atmosphère dans la première chambre à vide auxiliaire et la deuxième chambre à vide auxiliaire, respectivement, de sorte que chacune de la première chambre à vide auxiliaire et de la deuxième chambre à vide auxiliaire présente un degré de vide différent de celui de la chambre à vide, en formant ainsi le premier film de polymère déposé en phase vapeur sur le premier film métallique déposé en phase vapeur dans la première chambre à vide auxiliaire par le premier moyen de polymérisation de dépôt en phase vapeur et le deuxième film de polymère déposé en phase vapeur sur le deuxième film métallique déposé en phase vapeur dans la deuxième chambre à vide auxiliaire par le deuxième moyen de polymérisation de dépôt en phase vapeur.

6. Appareil de production d'une feuille multicouche selon la revendication 4 ou 5, comprenant en outre un premier moyen de traitement au plasma (56) et un deuxième moyen de traitement au plasma (80) dans la chambre de vide, le premier moyen de traitement au plasma introduisant une structure tridimensionnelle réticulée dans le premier film de polymère déposé en phase vapeur, et le deuxième moyen de traitement au plasma introduisant une structure tridimensionnelle réticulée dans le deuxième film de polymère déposé en phase vapeur.

7. Appareil de production d'une feuille multicouche selon l'une quelconque des revendications 1 à 6, dans lequel la feuille multicouche est utilisée pour produire un condensateur à feuille.

8. Procédé de production d'une feuille multicouche, comprenant les étapes de :
réaliser un appareil de dépôt (20) incluant une chambre à vide (22) ayant un premier rouleau (32), un deuxième rouleau (34) et un troisième rouleau (36) dans celui-ci, dans lequel un film de résine (12) dans la chambre à vide est enroulé sur le premier rouleau, le deuxième rouleau et le troisième rouleau dans l'ordre de la description ;
faire passer le film de résine du côté du premier rouleau au côté du troisième rouleau pendant que la chambre à vide se trouve à l'état de vide, le film de résine étant enroulé sur le premier rouleau et le deuxième rouleau de telle sorte qu'une surface du film de résine est orientée vers l'extérieur et que le film de résine transmis du deuxième rouleau est enroulé sur le troisième rouleau de telle sorte que l'autre surface de celui-ci soit orientée vers l'extérieur ;
former un premier film métallique déposé en phase vapeur (14) sur la surface précitée du film de résine à une périphérie du premier rouleau ;
former un premier film de polymère déposé en phase vapeur (18) sur le premier film métallique déposé en phase vapeur formé sur la surface précitée du film de résine, à une périphérie du deuxième rouleau ; et
former un deuxième film métallique déposé en phase vapeur (16) sur l'autre surface du film de résine, à une périphérie du troisième rouleau,
moyennant quoi la feuille multicouche comprenant le film de résine, le premier film métallique déposé en phase vapeur, le deuxième film métallique déposé en phase vapeur et le premier film de polymère déposé en phase vapeur est obtenue.

9. Procédé de production d'une feuille multicouche selon la revendication 8, comprenant en outre l'étape consistant à traiter le premier film de polymère déposé en phase vapeur par un traitement au plasma, moyennant quoi une structure tridimensionnelle réticulée est introduite dans le premier film de polymère déposé en phase vapeur.

10. Procédé de production d'un condensateur à feuille, comprenant l'étape consistant à enrouler la feuille multicouche obtenue selon la revendication 8 ou 9 au moins une fois, ou bien empiler une pluralité de feuilles multicouches les unes sur les autres.

11. Procédé de production d'un condensateur à feuille selon la revendication 10, dans lequel le premier film de polymère déposé en phase vapeur est un film de résine de poly-urée.

12. Procédé de production d'un condensateur à feuille selon la revendication 10 ou 11, dans lequel le premier film de polymère déposé en phase vapeur possède une constante diélectrique plus élevée que le film de résine.

13. Procédé de production d'un condensateur à feuille selon l'une quelconque des revendications 10 à 12, dans lequel le premier film de polymère déposé en phase vapeur est formé pour avoir une épaisseur dans la plage de 0,01 à 10 µm.

14. Procédé de production d'un condensateur à feuille selon l'une quelconque des revendications 10 à 13, dans lequel le film de résine est réalisé en polypropylène, et le premier film de polymère déposé en phase vapeur est réalisé en une résine de poly-urée.

15. Procédé de production d'une feuille multicouche selon la revendication 8, dans lequel la chambre à vide comprend en outre un quatrième rouleau (64), et le film de résine dans la chambre à vide est amené à passer du côté du premier rouleau au côté du quatrième rouleau pendant que le film de résine est encore enroulé sur le quatrième rouleau de sorte que l'autre surface de celui-ci est orientée vers l'extérieur, en formant ainsi en outre un deuxième film de polymère déposé en phase vapeur (19) sur le deuxième film métallique déposé en phase vapeur (14) formé sur l'autre surface du film de résine (16), à une périphérie du quatrième rouleau,
moyennant quoi la feuille multicouche comprenant le film de résine, le premier film métallique déposé en phase vapeur, le deuxième film métallique déposé en phase vapeur, le premier film de polymère déposé en phase vapeur et le deuxième film polymère déposé en phase vapeur est obtenue.
